# EUROPEAN PATENT APPLICATION

(11) **EP 3 650 579 A1**
(43) Date of publication of application: **13.05.2020**
(21) Application number: 18824796.9
(22) Date of filing: 21.06.2018
(51) Int. Cl.: C23C 18/34, H01L 21/28, H01L 21/288, H01L 21/3205, H01L 21/768, H01L 23/522, H01L 23/532, H05K 3/18

(54) **ELECTROLESS NICKEL STRIKE PLATING SOLUTION AND METHOD FOR FORMING NICKEL PLATING FILM**

(30) Priority: 28.06.2017 JP 2017126053
(71) Applicant: Kojima Chemicals Co. Ltd., Sayama-shi, Saitama 350-1335 (JP)
(72) Inventor: KATO, Tomohito, Sayama-shi Saitama 350-1335 (JP); WATANABE, Hideto, Sayama-shi Saitama 350-1335 (JP)
(74) Representative: Vossius & Partner Patentanwälte Rechtsanwälte mbB
(86) International application number: PCT/JP2018/023631
(87) International publication number: WO 2019/004057

(57) **Abstract**

An object of the present invention is to provide an electroless nickel plating solution that can form a nickel film which can surely cover a surface of a copper material even when the film thickness is thin, and a method for forming a nickel film using the electroless nickel plating solution. In order to solve the above-mentioned problems, the electroless nickel strike plating solution used for forming the nickel film on the surface of the copper material includes: a water-soluble nickel salt in a concentration of 0.002 to 1 g/L in terms of nickel; one or more carboxylic acids or salts thereof; and one or more reducing agents selected from the group of dimethylamine borane, trimethylamine borane, hydrazine and hydrazine derivatives.

## Description

### [Technical Field]

The present invention relates to an electroless nickel strike plating solution used for forming a nickel film on a surface of a copper material, and to a method for forming a nickel film using the same.

### [Background Art]

In recent years, demands have been increasing for a higher function and more multiple function of electronic equipment, but electronic circuit boards such as a resin substrate, a ceramic substrate and a wafer substrate, which are used in these electronic equipment, are required to become further lighter, thinner, shorter and smaller. In order to cope with this tendency of being lighter, thinner, shorter and smaller, high density mounting of electronic parts is necessary, and accordingly a surface treatment technology is required which can achieve the high density mounting of electronic parts. In addition, in a technological field of electronic circuit boards, a mounting technology using solder or wire bonding has been established as a technology for bonding mounted components.

For the purpose of ensuring the connection reliability at the time of mounting, plating treatment is performed as surface treatment, on a wiring pad which is a mounting portion of a circuit pattern on an electronic circuit board. For example, a nickel film and a gold film are sequentially formed by plating treatment, on a circuit pattern which is formed of a low resistance metal such as copper. Hereinafter, a formed of the nickel film and the gold film which have been sequentially formed will be described as "Ni/Au film". The nickel film is formed so as to prevent the diffusion of copper into the gold film, and the gold film is formed so as to obtain adequate mounting characteristics.

Furthermore, a technology of forming a palladium film between a nickel film and a gold film is also known. Hereinafter, a formed of the nickel film, the palladium film and the gold film which have been sequentially formed will be described as "Ni/Pd/Au film". The palladium film is formed in order to prevent nickel from diffusing into the gold film when the plated substrate is heat treated. When the palladium film has been formed on the nickel film, it becomes possible to thin the nickel film.

As the above described plating treatment, an electrolytic plating process is the mainstream, but an electroless plating process is applied to those which the electrolytic plating process cannot cope with.

Conventionally, as a technology of forming an Ni/Pd/Au film on a surface of copper, an electroless plating process is disclosed, for example, in Patent Literature 1, which adsorbs a palladium catalyst to a surface of a copper material that has been subjected to pretreatment such as degreasing and etching, and then performs electroless nickel plating, electroless palladium plating and electroless gold plating. In the electroless nickel plating, an electroless nickel plating solution is used which contains nickel sulfate hexahydrate of a concentration of 22.5 g/L (5 g/L in terms of nickel), sodium hypophosphite as a reducing agent, and malic acid and succinic acid as complexing agents, also contains a lead salt, a bismuth salt, a sulfur compound and/or the like as stabilizers, and has a pH adjusted to 4.6 and a bath temperature adjusted to 60 to 90°C. It is described that in place of sodium hypophosphite, dimethylamine borane can be used as the reducing agent. In addition, it is described that the nickel film of which the film thickness is 0.1 to 15 µm, the palladium film of which the film thickness is 0.001 to 2 µm, and the gold film of which the film thickness is 0.001 to 1 µm are formed, on a surface of a copper material by the above described electroless plating process.

In order to achieve further high density mounting of electronic parts in the Ni/Au film or the Ni/Pd/Au film, it is desired to further thin the nickel film.

### [Citation List]

### [Patent Literature]

[Patent Literature 1] Japanese Patent Laid-Open No. 2008-174774

### [Summary of Invention]

### [Technical Problem]

However, when an extremely thin nickel film of which the film thickness is, for example, 0.01 µm or less is formed with the use of the above described electroless nickel plating solution, there is a case where the covering becomes insufficient and a non-deposition superfine area (hole) is formed on the surface of the nickel film. Then, when the subsequent electroless gold plating (S17) has been performed, there is a case where the non-deposition superfine area is corroded and a through hole is formed which penetrates through the nickel film (nickel local corrosion phenomenon). In that case, there is a disadvantage in the Ni/Au film or the Ni/Pd/Au film that excellent mounting characteristics cannot be obtained.

An object of the present invention is to provide an electroless nickel plating solution that can form a nickel film which can surely cover a surface of a copper material even when the film thickness is thin, and a method for forming a nickel film using the electroless nickel plating solution.

### [Solution to Problem]

An electroless nickel strike plating solution according to the present invention is an electroless nickel strike plating solution used for forming a nickel film on a surface of a copper material, and includes a water-soluble nickel salt in a concentration of 0.002 to 1 g/L in terms of nickel, one or more carboxylic acids or salts thereof, and one or more reducing agents selected from the group of dimethylamine borane, trimethylamine borane, hydrazine and a hydrazine derivative.

In the electroless nickel strike plating solution according to the present invention, it is preferable that the carboxylic acid is one or more selected from the group consisting of a monocarboxylic acid, a dicarboxylic acid, a tricarboxylic acid, a hydroxydicarboxylic acid, a hydroxytricarboxylic acid, an aromatic carboxylic acid, an oxocarboxylic acid and an amino acid.

In the electroless nickel strike plating solution according to the present invention, it is preferable that the monocarboxylic acid is one or more selected from the group of formic acid, acetic acid, propionic acid and butyric acid.

In the electroless nickel strike plating solution according to the present invention, it is preferable that the dicarboxylic acid is one or more selected from the group of oxalic acid, malonic acid, succinic acid, gluconic acid, adipic acid, fumaric acid and maleic acid.

In the electroless nickel strike plating solution according to the present invention, it is preferable that the tricarboxylic acid is aconitic acid.

In the electroless nickel strike plating solution according to the present invention, it is preferable that the hydroxydicarboxylic acid is one or more selected from the group of lactic acid and malic acid.

In the electroless nickel strike plating solution according to the present invention, it is preferable that the hydroxytricarboxylic acid is citric acid.

In the electroless nickel strike plating solution according to the present invention, it is preferable that the aromatic carboxylic acid is one or more selected from the group of benzoic acid, phthalic acid and salicylic acid.

In the electroless nickel strike plating solution according to the present invention, it is preferable that the oxocarboxylic acid is pyruvic acid.

In the electroless nickel strike plating solution according to the present invention, it is preferable that the amino acid is one or more selected from the group of arginine, asparagine, aspartic acid, cysteine, glutamic acid and glycine.

It is preferable that the electroless nickel strike plating solution according to the present invention is prepared by mixing and stirring the water-soluble nickel salt, the carboxylic acid or the salt thereof and water to prepare an aqueous solution containing a nickel complex, then mixing the reducing agent into the aqueous solution, and stirring the mixture.

A method for forming a nickel film according to the present invention is a method for forming a nickel film on a surface of a copper material, and includes forming a nickel film on a surface of a copper material by an electroless strike plating method using the electroless nickel strike plating solution.

In the method for forming a nickel film according to the present invention, it is preferable that a pH of the electroless nickel strike plating solution is adjusted to 6 to 10 and a bath temperature thereof is adjusted to 20 to 55°C.

It is preferable that the method for forming a nickel film according to the present invention forms a nickel film of which a film thickness is 0.005 to 0.3 µm.

### [Advantageous Effect of Invention]

According to the electroless nickel strike plating solution and the method for forming a nickel film according to the present invention, it is possible to obtain a nickel film which can surely cover the surface of the copper material even though the film thickness is thin, by directly forming the nickel film on the surface of a pretreated copper material by the electroless strike plating method.

### [Brief Description of Drawings]

[Figure 1] Figure 1 is an SEM photograph of a nickel film obtained by an electroless nickel strike plating solution of Example 1.
[Figure 2] Figure 2 is an SEM photograph of a nickel film obtained by an electroless nickel plating solution of Comparative Example 1.
[Figure 3] Figure 3 is an SEM photograph of a nickel film obtained by an electroless nickel plating solution of Comparative Example 2.
[Figure 4] Figure 4 is a graph showing results of having electrolyzed the nickel films obtained in Example 1 and Comparative Example 1, at a low potential.

### [Description of Embodiments]

Hereinafter, embodiments of an electroless nickel strike plating solution and a method for forming a nickel film using the same according to the present invention will be described.

### 1. Electroless nickel strike plating solution

An electroless nickel strike plating solution according to the present invention is used for forming a nickel film on a surface of a copper material, and contains a water-soluble nickel salt in a concentration of 0.002 to 1 g/L in terms of nickel, one or more carboxylic acids or salts thereof, and one or more reducing agents selected from the group of dimethylamine borane, trimethylamine borane, hydrazine and hydrazine derivatives. In the present specification, "one or more" means that it may be only one, or be two or more.

### Water-soluble nickel salt:

Examples of the water-soluble nickel salts to be used in the electroless nickel strike plating solution include nickel sulfate, nickel chloride, nickel carbonate, and nickel salts of organic acids such as nickel acetate, nickel hypophosphite, nickel sulfamate and nickel citrate. These may be used singly or in combinations of two or more. In the present invention, it is most preferable to use the nickel sulfate hexahydrate as the water-soluble nickel salt.

The electroless nickel strike plating solution contains the water-soluble nickel salt in a range of 0.002 to 1 g/L in terms of nickel. The content within the above range is 1/5 or less of a nickel concentration of 5 g/L in the electroless nickel plating solution of the conventional technology, and is considerably low concentration. The electroless nickel strike plating solution can achieve an adequate electroless nickel strike plating method if the content of the water-soluble nickel salt in terms of nickel is within the above described range.

It is not preferable that the content of the water-soluble nickel salt is less than 0.002 g/L in terms of nickel, because a deposition rate becomes excessively low, and accordingly it becomes necessary to lengthen an immersion time period in order to obtain a nickel film of a desired film thickness, which cannot satisfy the industrial productivity. On the other hand, it is not preferable that the content of the water-soluble nickel salt exceeds 1 g/L in terms of nickel, because the deposition rate becomes excessively high, and there is a case where a nickel film having adequate surface properties cannot be obtained. It is more preferable for the content of the water-soluble nickel salt in terms of nickel to be in a range of 0.01 to 0.5 g/L, and is most preferable to be in a range of 0.03 to 0.1 g/L.

### Carboxylic acid or a salt thereof:

The electroless nickel strike plating solution contains a carboxylic acid or a salt thereof. They act as complexing agents and pH adjusting agents. As the carboxylic acid, one or more can be used which are selected from: monocarboxylic acids (formic acid, acetic acid, propionic acid, butyric acid and the like); dicarboxylic acids (oxalic acid, malonic acid, succinic acid, gluconic acid, adipic acid, fumaric acid, maleic acid and the like); tricarboxylic acids (aconitic acid and the like); hydroxydicarboxylic acids (lactic acid and malic acid); Hydroxytricarboxylic acid (citric acid), aromatic carboxylic acids (benzoic acid, phthalic acid, salicylic acid and the like); oxocarboxylic acids (pyruvic acid and the like); and amino acids (arginine, asparagine, aspartic acid, cysteine, glutamic acid, glycine and the like).

It is preferable to use the carboxylic acid or a salt thereof in a range of 0.5 to 5 g/L in total, and is more preferable to use the carboxylic acid or a salt thereof in a range of 0.8 to 2 g/L. In the electroless nickel strike plating solution of the present embodiment, the nickel content is lower than that of the electroless nickel plating solution of the conventional technology, and accordingly the content of the carboxylic acid or the salt thereof is set low. It is not preferable that the content of the carboxylic acid or the salt thereof is less than 0.5 g/L, though depending on the type, because it becomes insufficient for nickel ions in the electroless nickel strike plating solution to form complexes, and precipitation occasionally occurs. On the other hand, it is also not preferable that the content of the carboxylic acid or the salt thereof exceeds 5 g/L, because not only a special effect cannot be obtained but also resources are wasted.

### Reducing agent:

The electroless nickel strike plating solution contains one or more reducing agents selected from the group of dimethylamine borane, trimethylamine borane, hydrazine and a hydrazine derivative. The electroless nickel strike plating solution can achieve the nickel deposition on a surface of a copper material to which the palladium catalyst is not adsorbed, by using these substances as reducing agents. From the viewpoint of safety to the human body, the dimethylamine borane and the trimethylamine borane are more preferable.

It is preferable to use the reducing agent in a range of 2 to 10 g/L, and is more preferable to use the agent in a range of 4 to 8 g/L. It is not preferable that the content of the above described reducing agent is less than 2 g/L, because there is a case where a sufficient reducing action cannot be obtained and the nickel deposition on the copper surface does not progress. It is not preferable that the content of the above described reducing agent exceeds 10 g/L, because there is a case where nickel deposits on another surface (abnormal nickel deposition) than that of copper (surface of insulating base material), or the decomposition of a bath of the electroless nickel strike plating solution occurs.

The electroless nickel strike plating solution is prepared by mixing the above described components with water, stirring the mixture and dissolving the components. It is more preferable that the electroless nickel strike plating solution is prepared by mixing and stirring the above described water-soluble nickel salt, the above described carboxylic acid or a salt thereof, and water to prepare an aqueous solution containing a nickel complex, then mixing the above described reducing agent into the aqueous solution, and stirring the mixture. In the electroless nickel strike plating solution thus prepared, the nickel complex can stably exist for a long period of time, and excellent bath stability can be obtained.

Besides the above described components, the electroless nickel strike plating solution may contain components such as a sulfate, boric acid and a chloride salt.

As for the electroless nickel strike plating solution of the present embodiment, the content of the water-soluble nickel salt is as low as 0.002 to 1 g/L, and accordingly it is possible to extend the lifetime of the solution even without using a stabilizer such as a lead salt or a bismuth salt, unlike the electroless nickel plating solution of the conventional technology. In addition, the above described electroless nickel strike plating solution does not contain the stabilizer such as the lead salt and the bismuth salt, and accordingly it is possible to obtain a nickel film which does not contain a heavy metal such as lead and bismuth.

### 2. Method for forming nickel film

The method for forming a nickel film of the present embodiment is a method for forming a nickel film on a surface of a copper material, and includes forming the nickel film on the surface of the copper material with the use of the above described electroless nickel strike plating solution, by an electroless strike plating method.

The copper material is subjected to a pretreatment, before being subjected to the electroless nickel strike plating method. Examples of the copper material include: an electrode or a wire which is formed from copper or a copper alloy and is provided on a surface of an insulating base material such as a resin substrate, a ceramic substrate and a wafer substrate; and a copper plate which is formed from copper or a copper alloy. The pretreatment can be performed by a known method: and is performed, for example, by: degreasing with an acidic solution; etching of removing a copper oxide film with an etching solution such as a persulfate-based solution, a hydrogen peroxide-based solution and a thiol-based solution; and desmutting of removing smut with 10% sulfuric acid.

In the conventional electroless nickel plating, a palladium catalyst adsorption treatment to the surface of the copper material is performed following the above described pretreatment. In contrast to this, in the method for forming a nickel film of the present embodiment, the palladium catalyst adsorption treatment is not needed.

Subsequently, the electroless nickel strike plating method is performed by immersing the pretreated copper material in the above described electroless nickel strike plating solution. In order to achieve the electroless nickel strike plating method, it is preferable that the electroless nickel strike plating solution is adjusted so that a pH is in a range of 6 to 10 and a bath temperature is in a range of 20 to 55°C.

It is not preferable that the pH of the above described electroless nickel strike plating solution is lower than 6, because a deposition rate of nickel decreases and a forming property of the nickel film lowers, and pores and non-deposition superfine areas (holes) are occasionally formed on the surface of the nickel film. On the other hand, it is not preferable that the pH exceeds 10, because there are cases where the deposition rate of nickel becomes excessively high, which makes it difficult to control the film thickness of the nickel film, and the crystalline state of depositing nickel cannot be densified.

The above described bath temperature of the electroless nickel strike plating solution is a value lower than the bath temperature of 60 to 90°C in the electroless nickel plating solution of the conventional technology. It is not preferable that the bath temperature is lower than 20°C, because the deposition rate of nickel decreases, the forming property of the nickel film lowers, and there is a case where pores and non-deposition superfine areas (holes) are formed on the surface of the nickel film, or no nickel deposition occurs. On the other hand, it is not preferable that the bath temperature exceeds 55°C, because the bath stability of the electroless nickel strike plating solution decreases, and the electroless strike plating method cannot be occasionally achieved.

In the method for forming a nickel film of the present embodiment, one or more substances selected from the group of dimethylamine borane, trimethylamine borane, hydrazine and hydrazine derivatives which are contained in the electroless nickel strike plating solution act as reducing agents. Because of this, the method can deposit nickel directly on the surface of the pretreated copper material, in spite of the fact that a palladium catalyst is not adsorbed to the surface of the copper material, unlike the conventional electroless nickel plating. In addition, the nickel content of the electroless nickel strike plating solution is low; and besides, the pH is adjusted to 6 to 10, and the bath temperature is adjusted to 20 to 55°C. Thereby, the deposition rate of nickel can be lowered, the electroless nickel strike plating method can be achieved, and the nickel film can be formed on the surface of the copper material. At this time, the deposition rate of nickel is low, accordingly it is possible to uniformly deposit nickel on the surface of the copper material, and as a result, it is possible to form a nickel film which is uniform in film thickness, surely can cover the surface of the copper material even though the film thickness is thin, and is excellent in adhesiveness to the copper material and barrier properties. Accordingly, it is possible to achieve the thinning of the nickel film. The obtained nickel film is excellent in adhesiveness to the copper material and excellent in barrier properties, i.e., prevention of the diffusion of copper.

In contrast to this, in the electroless nickel plating of the conventional technology, the palladium which has been adsorbed to the surface of the copper material acts as a catalyst, and the nickel deposition progresses. Because of this, variations of the film thicknesses of the nickel film which is formed occur between a region in which the palladium catalyst has been adsorbed and a region in which the palladium catalyst has not been adsorbed, on the surface of the copper material, and it is difficult to obtain the nickel film of which the film thickness is uniform.

In the method for forming a nickel film of the present embodiment, when the dimethylamine borane or the trimethylamine borane is used as the reducing agent which is contained in the electroless nickel strike plating solution, it is possible to obtain a nickel plating formed from an alloy of nickel and boron (nickel-boron alloy). This nickel film contains a very small amount of boron (for example, 0.1% or less), and is a nickel film which is substantially formed of pure nickel. In addition, when the hydrazine or the hydrazine derivative is used as a reducing agent, it is possible to obtain a nickel plating formed of pure nickel.

The film thickness of the nickel film is adjusted by the immersion time period in the electroless nickel strike plating solution. It is preferable for the film thickness of the nickel film to be as thin as possible within a range that can prevent copper diffusion, but according to the method for forming a nickel film of the present embodiment, it is possible to achieve a film thickness of 0.005 to 0.3 µm. When the film thickness of the nickel film is less than 0.005 µm, there is a case where it becomes insufficient to cover the surface of the copper material, and non-deposition superfine areas are formed on the surface of the nickel film. In the case, there are cases where a nickel local corrosion phenomenon occurs when a subsequent electroless gold plating step has been performed, and copper and nickel diffuse into the surface of the gold film, which are not preferable. On the other hand, it is possible to form a nickel film of which the film thickness exceeds 0.3 µm, but is not preferable because the flexibility of the nickel film lowers, and besides, resources are wasted. Furthermore, in order to achieve the thinning of the film while ensuring favorable mounting characteristics, it is more preferable that the film thickness of the nickel film which is formed by the method for forming a nickel film of the present embodiment is 0.007 to 0.1 µm.

Furthermore, an Ni/Au film or Ni/Pd/Au film can be obtained, by forming a palladium film or a gold film on the surface of the nickel film which has been obtained by the forming method of the present embodiment, for example, by an electroless plating method. As an electroless plating method, a substitution -type electroless plating method and a reduction-type electroless plating method are known. However, when the palladium film or the gold film is formed by a substitution-type electroless plating method, there is a case where a nickel local corrosion phenomenon occurs, specifically, a phenomenon in which nickel dissolves and a through hole penetrating the nickel film is formed occurs. Because of this, it is preferable to form the palladium film or the gold film, by the reduction-type electroless plating method.

As described above, the nickel film which has been formed by the forming method of the present embodiment is uniform in the film thickness and is excellent in the smoothness, and accordingly it is possible to form the palladium film and the gold film into a uniform film thickness, which is formed on the nickel film. In addition, the nickel film is excellent in the adhesiveness to the copper material and excellent in the barrier properties of preventing the diffusion of copper, and accordingly the Ni/Au film or the Ni/Pd/Au film can obtain excellent mounting characteristics.

Hereinafter, the present invention will be specifically described on the basis of examples and the like.

### [Example 1]

In the present example, firstly, degreasing, etching and desmutting were performed on a copper material as pretreatment. Next, the electroless nickel strike plating method was applied to a desmutted copper material, and a nickel film of which the film thickness was 0.01 µm was formed on a surface of the copper material. In the electroless nickel strike plating method, the copper material was immersed in an electroless nickel strike plating solution having the following composition. The electroless nickel strike plating solution was prepared by mixing and stirring nickel sulfate hexahydrate, DL-malic acid and water to prepare an aqueous solution containing a nickel complex, then adding dimethylamine borane, and stirring the mixture. While the copper material was immersed in the electroless nickel strike plating solution, the electroless nickel strike plating solution was stirred by aeration.

### (Electroless nickel strike plating solution)

Nickel sulfate hexahydrate 0.2 g/L (0.045 g/L in terms of nickel)
DL-malic acid 1.0 g/L
Dimethylamine borane 4.0 g/L
pH 9.0
Bath temperature 50°C

Then, an electroless palladium plating step (S5) was performed. A copper material on which the nickel film was formed was immersed in a reduction-type electroless palladium plating solution having the following composition, and a palladium film was formed on the surface of the nickel film.

### (Reduction-type electroless palladium plating solution)

Palladium chloride 0.038 mol/L
Ethylenediamine 0.142 mol/L
Sodium formate 0.294 mol/L
pH 6.0
Bath temperature 70°C

After that, a copper material on which the palladium film was formed was immersed in a reduction-type electroless gold plating solution having the following composition, and a gold film was formed on the surface of the palladium film. By the above steps, the Ni/Pd/Au film was formed on the surface of the copper material.

### (Reduction-type electroless gold plating solution)

Gold potassium cyanide 5 mmol/L
Dipotassium ethylenediaminetetraacetate 0.03 mol/L
Citric acid 0.15 mol/L
Hexamethylenetetramine 3 mmol/L
3,3'-Diamino-N-methyldipropylamine 0.02 mol/L
Thallium acetate 5 mg/L
pH 8.5
Bath temperature 80°C

### [Example 2]

In the present example, a nickel film was formed in exactly the same way as that of Example 1, except that an electroless nickel strike plating solution having the following composition was prepared. The electroless nickel strike plating solution was prepared by mixing and stirring nickel sulfate hexahydrate, a carboxylic acid and water to prepare an aqueous solution containing a nickel complex, then adding dimethylamine borane, and stirring the mixture. As the carboxylic acid, one or two carboxylic acids were selected from the group of acetic acid, formic acid, malonic acid, oxalic acid, malic acid, citric acid and glycine. When two of carboxylic acids were used, one of which the additional amount was larger was determined as a main carboxylic acid, and one of which the additional amount was smaller was determined as a secondary carboxylic acid.

### (Electroless nickel strike plating solution)

Nickel sulfate hexahydrate 0.2 g/L (0.045 g/L in terms of nickel)
One or two of carboxylic acids the total amount is 1.0 to 3.0 g/L
Dimethylamine borane 4.0 g/L
pH 9.0
Bath temperature 50°C

### [Example 3]

In the present example, an electroless nickel strike plating solution was prepared which contained the same amount of the same components as those in the electroless nickel strike plating solution of Example 1. In the present example, the preparation method was different from that of the electroless nickel strike plating solution of Example 1, and an electroless nickel strike plating solution which was an aqueous solution containing a nickel complex was prepared by mixing the nickel sulfate hexahydrate, DL-malic acid, dimethylamine borane and water, and stirring the mixture.

### [Comparative Example]

### [Comparative Example 1]

In the present comparative example, a nickel film was formed in a similar way to that of Example 1, except that an electroless nickel plating solution having the following composition was used in place of the electroless nickel strike plating solution, and then a palladium film and a gold film were formed. However, the electroless nickel plating solution of the present comparative example cannot deposit nickel at all when the palladium catalyst was not adsorbed to the surface of the copper material, accordingly the copper material was immersed in a palladium catalyst-containing solution before being immersed in the electroless nickel plating solution, and the palladium catalyst was adsorbed to the surface of the copper material.

### (Electroless nickel plating solution)

Nickel sulfate hexahydrate 22.4 g/L (5 g/L in terms of nickel)
DL-malic acid 15 g/L
Lactic acid 18 g/L
Sodium hypophosphite 30 g/L
pH 4.5
Bath temperature 80°C

### [Comparative Example 2]

In the present comparative example, a nickel film was formed in a similar way to that of Comparative Example 2, except that an electroless nickel plating solution having the following composition was used. However, the electroless nickel plating solution of the present comparative example also could not deposit nickel at all when the palladium catalyst was not adsorbed to the surface of the copper material, similarly to the electroless nickel plating solution of Comparative Example 1, accordingly the copper material was immersed in a palladium catalyst-containing solution before being immersed in the electroless nickel plating solution, and the palladium catalyst was adsorbed to the surface of the copper material.

### (Electroless nickel plating solution)

Nickel sulfate hexahydrate 22.4 g/L (5 g/L in terms of nickel)
Glycolic acid 30 g/L
Acetic acid 15 g/L
Dimethylamine borane 2.5 g/L
pH 6.0
Bath temperature 60°C

### <Evaluation>

### 1. Evaluation for nickel film

Firstly, nickel films which were formed by the electroless nickel strike plating solution of Example 1 and the electroless nickel plating solutions of Comparative Examples 1 and 2 were subjected to the following evaluations.

### 1-1. Nickel deposition property

Here, a test board was used in which 30 copper pads of which the diameter is 0.45 mm were arranged on an insulating base material in a lattice pattern at spaces of 30 µm. Then, nickel films of which the film thicknesses were 0.01 µm were formed on surfaces of the copper pads, by the electroless nickel strike plating solution of Example 1 and the electroless nickel plating solutions of Comparative Examples 1 and 2.

Then, the obtained nickel films were observed with a metallurgical microscope (magnification of 1000 times), and the numbers of copper pads were counted on which nickel was normally deposited. Here, "the nickel was normally deposited" means that the whole surface of the copper pad is covered with the nickel film, and the uncovered part is not confirmed with the metallurgical microscope. The results are shown in Table 1. The determination criteria of ○ and △ in Table 1 are as follows.
○: Copper pads on which nickel is normally deposited are 30 pads.
△: Copper pads on which nickel is normally deposited are 15 to 29 pads.

**[Table 1]**

| Example 1 | Comparative Example 1 | Comparative Example 2 |
|---|---|---|
| ○ | ○ | Δ |

As shown in Table 1, it can be understood that the electroless nickel strike plating solution of Example 1 can always normally deposit nickel and is excellent in the nickel deposition property. On the other hand, it can be understood that the electroless nickel plating solution of Comparative Example 1 can always normally deposit nickel, but the electroless nickel plating solution of Comparative Example 2 sometimes fails to normally deposit nickel, and is inferior in the nickel deposition property.

### 1-2. Surface morphology

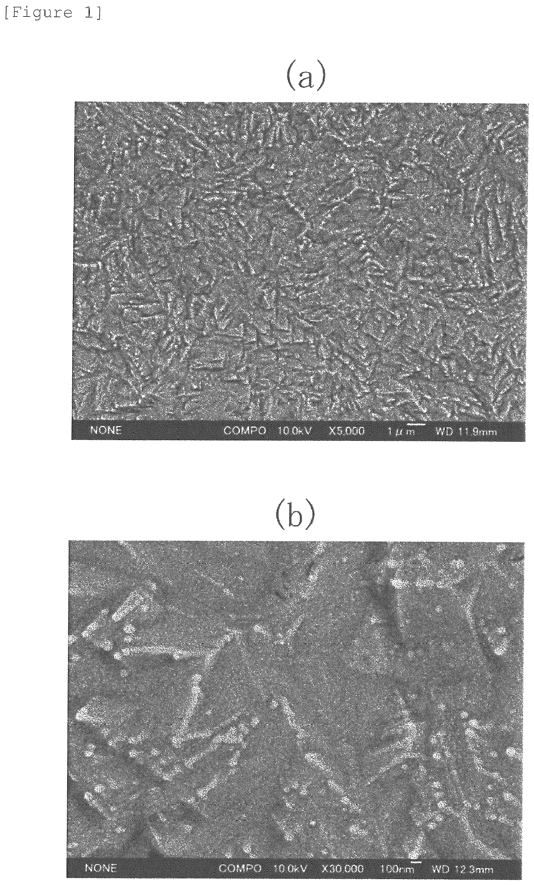

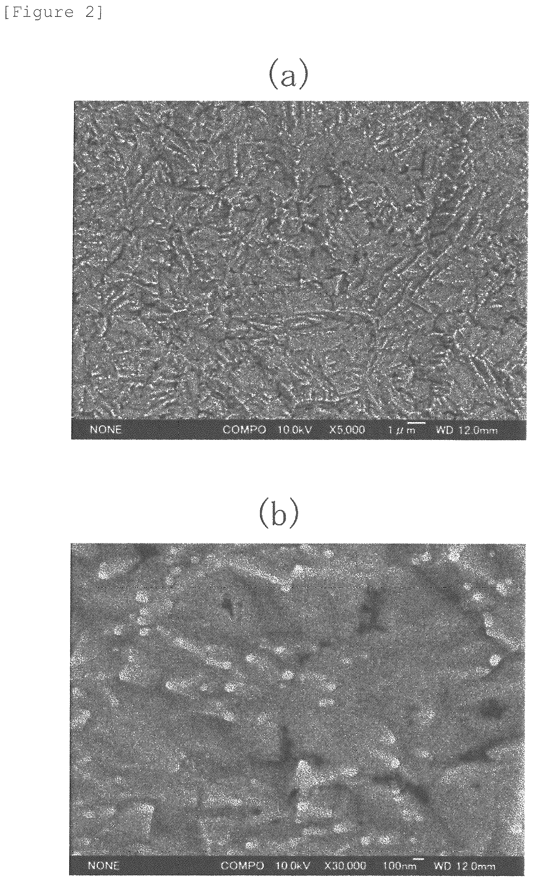

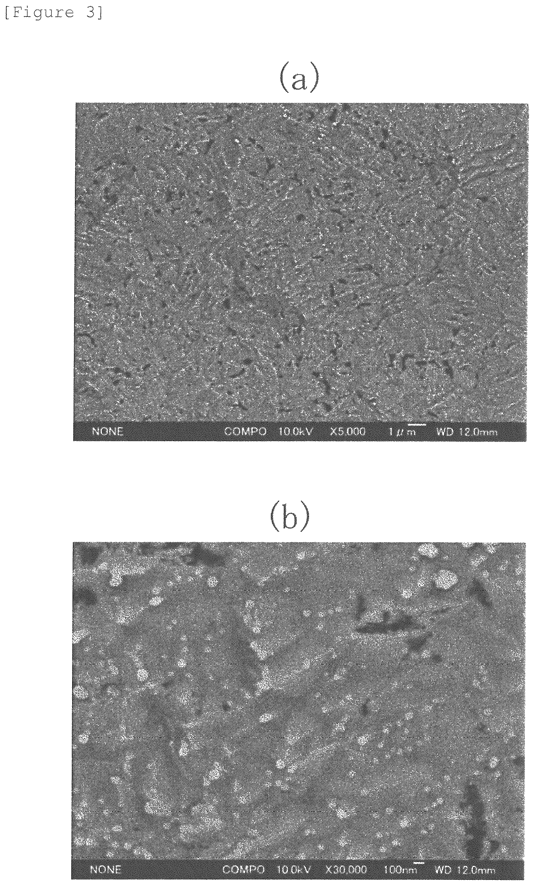

In order to evaluate a surface morphology of the nickel film which was formed on the surface of the copper pad, the surface of the nickel film was photographed with a scanning electron microscope (SEM) at magnifications of 5000 times and 30000 times, and a backscattered electron compositional image (COMPO image) was obtained. The results are shown in Figures 1 to 3. Figure 1 shows a COMPO image of the nickel film which was obtained by the electroless nickel strike plating solution of Example 1; Figure 2 shows a COMPO image of the nickel film which was obtained by the electroless nickel plating solution of Comparative Example 1; and Figure 3 shows a COMPO image of the nickel film which was obtained by the electroless nickel plating solution of Comparative Example 2. Magnifications of Figures 1(a), 2(a) and 3(a) are 5000 times, and magnifications of Figure 1(b), Figure 2(b) and Figure 3(b) are 30000 times.

It can be confirmed from Figure 1 to Figure 3 that in the nickel film obtained by the electroless nickel strike plating solution of Example 1, there are few black portions as compared with the nickel films obtained by electroless nickel plating solution of Comparative Example 1 and Comparative Example 2. The black portion indicates that elements such as carbon, of which the atomic numbers are small, exist on the nickel film. From this result, it can be understood that the nickel film obtained by the electroless nickel strike plating solution of Example 1 has few defects and is a dense film, as compared with the nickel films obtained by electroless nickel plating solution of Comparative Example 1 and Comparative Example 2. In addition, the nickel film obtained by the electroless nickel plating solution of Comparative Example 2 shows particularly many black portions, and it can be understood from the result that the nickel film has many defect portions and is not a dense film.

Furthermore, it can be confirmed that in the nickel films obtained by the electroless nickel plating solution of Comparative Example 1 and Comparative Example 2, film roughness is large, but on the other hand, in the nickel film obtained by the electroless nickel strike plating solution of Example 1, film roughness is fine. From this result, it can be understood that the nickel film obtained by the electroless nickel strike plating solution of Example 1 is excellent in smoothness, as compared with the nickel film obtained by electroless nickel plating solution of Comparative Example 1 and Comparative Example 2. In addition, in the nickel film of Comparative Example 2, film roughness is large, and it can be understood from the result that the nickel film is inferior in the smoothness.

It can be understood from the above description that the nickel film can be obtained which is dense and is excellent in the smoothness, according to the electroless nickel strike plating solution of Example 1, as compared to the electroless nickel plating solution of Comparative Example 1 and Comparative Example 2.

### 1-3. Surface elemental analysis

The nickel film which was formed on the surface of the copper pad was subjected to a surface elemental analysis by an Auger Electron Spectroscopy Analyzer. As described above, the nickel film of Comparative Example 2 is inferior in the performance, and accordingly only the nickel film of Example 1 and Comparative Example 1 were targeted.

The nickel film was subjected to reflow treatment three times. The reflow treatment was performed by preliminarily heating the nickel film at 230°C, and then heating the resultant film at 250°C. The surface elemental analysis was performed before the nickel film was subjected to the reflow treatment and after the nickel film was subjected to the reflow treatment and then was naturally cooled to normal temperature. As for measurement conditions of the surface elemental analysis, an acceleration voltage was set at 10 kV, a probe current value was set at 10 nA, a measuring diameter was set at 50 µm, and a scanning range was set at 30 to 2400 eV. The results are shown in Table 2. The numerical values in Table 2 are values which have been obtained by quantifying the elements from the peak intensity ratio of the obtained spectrum (unit: atomic %). The mark - in Table 2 means that the corresponding element has not been detected at all.

**[Table 2]**

| | Number of reflows | Ni | P | Cu | C | N | O | S | Cl |
|---|---|---|---|---|---|---|---|---|---|
| Example 1 | 0 Time | 44.6 | - | - | 26.2 | - | 27.3 | - | 1.9 |
| | 1 Time | 21.9 | - | - | 52.9 | - | 25.2 | - | - |
| | 2 Times | 15. 1 | - | - | 63.4 | - | 21.5 | - | - |
| | 3 Times | 15. 1 | - | 1.7 | 62. 6 | - | 20.6 | - | - |
| Comparative Example 1 | 0 Time | 38.6 | 3.4 | - | 37.1 | - | 19 | - | 1.9 |
| | 1 Time | 21.6 | 1.7 | - | 58.2 | - | 17.3 | - | 1.2 |
| | 2 Times | 17.8 | 2.1 | 1.1 | 60.6 | - | 17.1 | - | 1.3 |
| | 3 Times | 15.6 | 2 | 1.2 | 63.5 | - | 17.7 | - | - |

It was thought that the nickel film obtained by the electroless nickel strike plating solution of Example 1 contained boron which originated in dimethylamine borane, but in fact, boron was not detected, and it was found that the nickel film was formed from substantially pure nickel. On the other hand, as shown in Table 2, the nickel film obtained by the electroless nickel plating solution of Comparative Example 1 was formed from a nickel-phosphorus alloy containing phosphorus which originated in sodium hypophosphite.

It can be understood from Table 2 that in the nickel film obtained by the electroless nickel strike plating solution of Example 1, copper did not diffuse to the surface thereof even after the second reflow treatment, and that a barrier performance was excellent. On the other hand, it can be understood that in the nickel film obtained by electroless nickel plating solution of Comparative Example 1, copper did not diffuse to the surface after the first reflow treatment, but diffused to the surface after the second reflow treatment, and that the barrier performance was inferior.

### 1-4. Low potential electrolysis

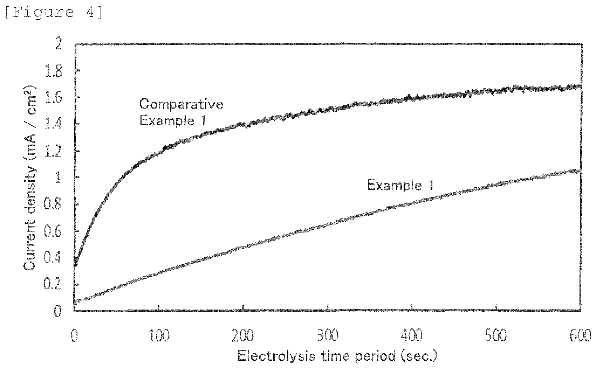

Here, a copper plate was used in place of the above described test board, and a nickel film of which the film thickness was 0.01 µm was formed on the surface of the copper plate. Then, the obtained nickel film was subjected to a low potential electrolysis of 50 mV in a 0.5% by volume of a sulfuric acid solution, and barrier properties were evaluated. The results are shown in Figure 4. In the figure, the horizontal axis is an electrolysis time period, and the vertical axis is a current density. The increase in the current density indicates that copper has dissolved from the copper material which is a lower layer of the nickel film.

As shown in Figure 4, it can be understood that the nickel film obtained by the electroless nickel strike plating solution of Example 1 shows a small increase in the current density, as compared with the nickel film obtained by the electroless nickel plating solution of Comparative Example 1, and accordingly is excellent in the barrier properties.

It can be understood from the results of the above nickel deposition property, surface morphology, surface elemental analysis and low potential electrolysis that the electroless nickel strike plating solution of Example 1 can obtain the nickel film which is excellent in the nickel deposition property, is dense and smooth, and is excellent in the barrier performance, as compared to the electroless nickel plating solutions of Comparative Example 1 and Comparative Example 2. Furthermore, it can be understood that the nickel film obtained by the electroless nickel strike plating solution of Example 1 has an excellent performance, as compared with the nickel films which have the same film thickness as the above nickel film and have been obtained by electroless nickel plating solutions of Comparative Example 1 and Comparative Example 2.

### 1-5. Selective deposition property

Here, a test board was used in which a wiring pattern of copper, of which the wiring width/ a wiring space (L/S) was 30 µm/ 30 µm, was provided on an insulating base material which had a solder resist on its surface and was formed from an epoxy resin. Then, nickel films of which the film thicknesses were 0.01 µm were formed on surfaces of the wiring patterns by the electroless nickel strike plating solutions of Example 2, in which the types of the carboxylic acids were different from each other.

Then, the obtained nickel films were subjected to visual observation whether or not a nickel deposition-free portion existed on the surface of the wiring pattern, in other words, a portion which was not covered with the nickel film existed thereon, and whether or not the nickel was deposited on the surface between the wiring patterns of the insulating base material; and the selective deposition property of the electroless nickel strike plating solutions was evaluated. The results are shown in Table 3. The determination criteria of ○, △ and × in Table 3 are as follows.
○: Nickel deposition-free portion did not exist on the surface of the wiring pattern, and nickel deposition did not occur between the wiring patterns.
△: Nickel deposition-free portion did not exist on the surface of the wiring pattern, but there was nickel deposition between the wiring patterns.
×: Nickel deposition-free portion existed on the surface of the wiring pattern, but nickel deposition did not occur between the wiring patterns.

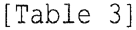

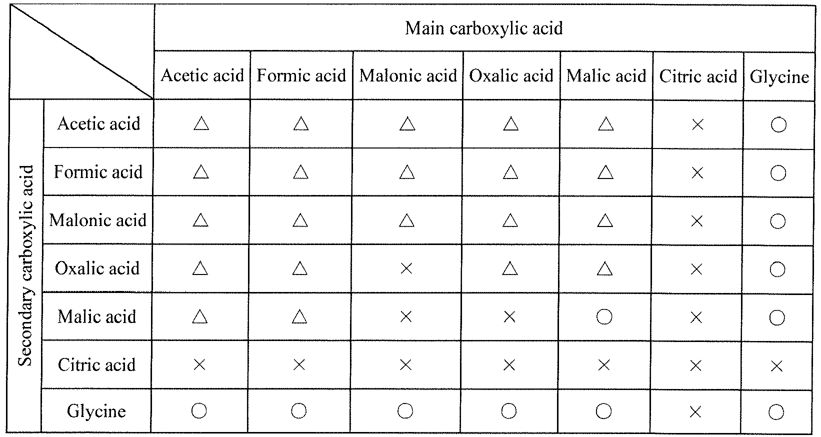

As shown in Table 3, electroless nickel strike plating solutions exhibiting the best selective deposition property were solutions in which a hydroxydicarboxylic acid (malic acid) or an amino acid (glycine) was solely used as a carboxylic acid, or one selected from the group of a monocarboxylic acid (acetic acid and formic acid), a dicarboxylic acid (malonic acid and oxalic acid) and a hydroxydicarboxylic acid (malic acid) was combined with an amino acid (glycine). Electroless nickel strike plating solutions exhibiting the second-best selective deposition property were solutions in which one selected from the group of a monocarboxylic acid (acetic acid and formic acid), a dicarboxylic acid (malonic acid and oxalic acid) and a hydroxydicarboxylic acid (malic acid) as the main carboxylic acid was used in combination with one selected from the group of a monocarboxylic acid (acetic acid and formic acid) and a dicarboxylic acid as a secondary carboxylic acid, or a monocarboxylic acid (acetic acid and formic acid) was combined with a hydroxycarboxylic acid (malic acid). On the other hand, the electroless nickel strike plating solutions in which citric acid was solely used or used in combination with another carboxylic acid did not show an adequate selective deposition property so much.

### 2. Evaluation concerning bath stability

### 2-1. Type of carboxylic acid

The electroless nickel strike plating solutions of Example 2, in which the types of the carboxylic acids were different from each other, were subjected to three cycles of which the cycle was to warm the solution to a temperature of 50°C for 8 hours, stop the warming for 16 hours to return the bath temperature back to normal temperature by natural cooling, and then warm the solution to 50°C again. Then, while the three cycles were performed, the presence or absence of bath decomposition of the electroless nickel strike plating solution was observed. The results are shown in Table 4. The determination criteria of ○, △ and × in Table 4 are as follows.
○: After the end of 3 cycles (after 72 hours), bath was not decomposed and was stable.
△: Bath was not decomposed during one cycle (within 24 hours), but bath was decomposed by the end of 3 cycles.
×: Bath was decomposed before the end of 1 cycle.

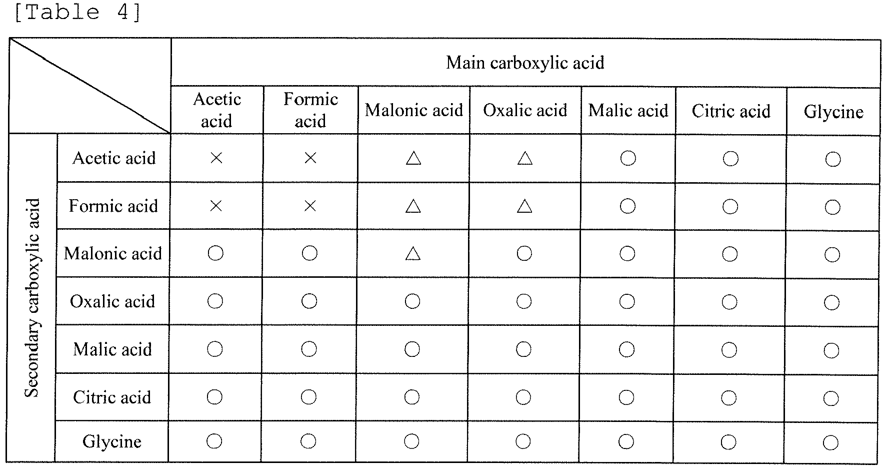

As shown in Table 4, electroless nickel strike plating solutions exhibiting the best bath stability were solutions in which a hydroxydicarboxylic acid (malic acid), a hydroxytricarboxylic acid (citric acid) or an amino acid (glycine) was solely used as the carboxylic acid, or was used in combination with another carboxylic acid. In addition, electroless nickel strike plating solutions were also particularly excellent in the bath stability, in which one selected from the group of a monocarboxylic acid (acetic acid and formic acid) and a dicarboxylic acid (malonic acid and oxalic acid) was used as the main carboxylic acid, and a dicarboxylic acid was used as a secondary carboxylic acid. Electroless nickel strike plating solutions exhibiting the second-best bath stability were solutions in which a dicarboxylic acid (malonic acid or oxalic acid) was used as a main carboxylic acid, and a monocarboxylic acid (acetic acid or formic acid) was used in combination as a secondary carboxylic acid. On the other hand, electroless nickel strike plating solutions were low in the bath stability, in which acetic acid or formic acid was solely used or a combination of the acetic acid and the formic acid was used.

It can be understood from Tables 3 and 4 that various carboxylic acids can be combined with each other in the electroless nickel strike plating solution. In addition, it can be understood that when it is desired to achieve both of the excellent selective deposition property and excellent bath stability, it is the best way to solely use a hydroxydicarboxylic acid (malic acid) or an amino acid (glycine), or to use a combination of one selected from the group of a monocarboxylic acid (acetic acid and formic acid), a dicarboxylic acid (malonic acid and oxalic acid) and a hydroxydicarboxylic acid (malic acid), with an amino acid (glycine).

### 2-2. Preparation method

The electroless nickel strike plating solutions of Example 1 and Example 3 were subjected to three cycles of which the cycle was to warm the solution and stop the warming, similarly to the electroless nickel strike plating solution of Example 2, and the presence or absence of the bath decomposition was observed. The results are shown in Table 5. The determination criteria of o and × in Table 5 are the same as those in Table 4.

**[Table 5]**

| | Example 1 | Example 3 |
|---|---|---|
| Bath stability | ○ | × |

As shown in Table 5, the electroless nickel strike plating solution of Example 1 was excellent in the bath stability, as compared with the electroless nickel strike plating solution of Example 3. From this result, it can be understood that the bath stability can be improved, when an electroless nickel strike plating solution is prepared, not by simply mixing the water-soluble nickel salt, the carboxylic acid or a salt thereof and the reducing agent with water, but by adopting a method of firstly mixing and stirring a water-soluble nickel salt, a carboxylic acid or a salt thereof and water to prepare an aqueous solution containing a nickel complex, and then mixing a reducing agent into the aqueous solution and stirring the mixture to prepare the plating solution.

### [Industrial Applicability]

As described above, according to the electroless nickel strike plating solution of the present invention, it is possible to form a nickel film which can surely cover the surface of the copper material even though the film thickness is thin, is excellent in the adhesiveness to the copper material, and is excellent in the barrier properties of preventing the diffusion of copper. Therefore, according to the electroless nickel strike plating solution of the present invention, it is possible to achieve the thinning of the nickel film. In addition, when an Ni/Au film or an Ni/Pd/Au film has been constituted by forming a palladium film or a gold film on the nickel film which has been formed by the electroless nickel strike plating solution, it is possible to obtain excellent mounting characteristics even though the film thickness of the nickel film is thin. As a result, it is possible to cope with a complicated wiring pattern and wiring with narrow pitches, and to achieve high density mounting of electronics parts. In addition, the obtained Ni/Au film or the Ni/Pd/Au film has a thin overall film thickness, is excellent in flexibility, and accordingly is suitable as a flexible substrate.

Furthermore, the electroless nickel strike plating solution according to the present invention can directly form a nickel film on the surface of the pretreated copper material even without performing the palladium catalyst adsorption treatment, and accordingly can improve the productivity.

## Claims

1. An electroless nickel strike plating solution used for forming a nickel film on a surface of a copper material, comprising:
a water-soluble nickel salt in a concentration of 0.002 to 1 g/L in terms of nickel;
one or more carboxylic acids or salts thereof; and
one or more reducing agents selected from the group of dimethylamine borane, trimethylamine borane, hydrazine and a hydrazine derivative.

2. The electroless nickel strike plating solution according to claim 1, wherein the carboxylic acid is one or more selected from the group consisting of a monocarboxylic acid, a dicarboxylic acid, a tricarboxylic acid, a hydroxydicarboxylic acid, a hydroxytricarboxylic acid, an aromatic carboxylic acid, an oxocarboxylic acid and an amino acid.

3. The electroless nickel strike plating solution according to claim 2, wherein the monocarboxylic acid is one or more selected from the group of formic acid, acetic acid, propionic acid and butyric acid.

4. The electroless nickel strike plating solution according to claim 2, wherein the dicarboxylic acid is one or more selected from the group of oxalic acid, malonic acid, succinic acid, gluconic acid, adipic acid, fumaric acid and maleic acid.

5. The electroless nickel strike plating solution according to claim 2, wherein the tricarboxylic acid is aconitic acid.

6. The electroless nickel strike plating solution according to claim 2, wherein the hydroxydicarboxylic acid is one or more selected from the group of lactic acid and malic acid.

7. The electroless nickel strike plating solution according to claim 2, wherein the hydroxytricarboxylic acid is citric acid.

8. The electroless nickel strike plating solution according to claim 2, wherein the aromatic carboxylic acid is one or more selected from the group of benzoic acid, phthalic acid and salicylic acid.

9. The electroless nickel strike plating solution according to claim 2, wherein the oxocarboxylic acid is pyruvic acid.

10. The electroless nickel strike plating solution according to claim 2, wherein the amino acid is one or more selected from the group of arginine, asparagine, aspartic acid, cysteine, glutamic acid and glycine.

11. The electroless nickel strike plating solution according to any one of claims 1 to 10, wherein the electroless nickel strike plating solution is prepared by mixing and stirring the water-soluble nickel salt, the carboxylic acid or a salt thereof and water to prepare an aqueous solution containing a nickel complex, then mixing the reducing agent into the aqueous solution, and stirring the mixture.

12. A method for forming a nickel film on a surface of a copper material, comprising
forming a nickel film on a surface of a copper material by an electroless strike plating method using the electroless nickel strike plating solution according to any one of claims 1 to 11.

13. The method for forming a nickel film according to claim 12, wherein a pH of the electroless nickel strike plating solution is adjusted to 6 to 10, and a bath temperature thereof is adjusted to 20 to 55°C.

14. The method for forming a nickel film according to claim 12 or 13, wherein a nickel film of which a film thickness is 0.005 to 0.3 µm is formed.
